# EUROPEAN PATENT APPLICATION

(11) **EP 2 762 810 A1**
(43) Date of publication of application: **06.08.2014**
(21) Application number: 13153815.9
(22) Date of filing: 04.02.2013
(51) Int. Cl.: F25D 21/14, H02B 1/56, F24F 3/14, F24F 13/22

(54) **Cooling assembly and dehumidification method**

(71) Applicant: ABB Oy, 00380 Helsinki (FI)
(72) Inventor: Koivuluoma, Timo, 00380 Helsinki (FI); Manninen, Jorma, 00380 Helsinki (FI)
(74) Representative: Kolster Oy Ab

(57) **Abstract**

A cooling assembly comprising a device chamber (2) containing device chamber cooling medium, heat exchanger means comprising at least one cooling surface (35, 15) in contact with the device chamber cooling medium, control means (6) adapted to control the heat exchanger means, humidity sensor means (61) adapted to detect a humidity level in the device chamber (2), and a receptacle (9), the control means (6) being adapted to provide a dehumidification operation as a response to the humidity level exceeding a predetermined threshold value in the device chamber (2). The dehumidification operation comprises lowering a temperature of the at least one cooling surface (35, 15) in order to condensate water from the device chamber cooling medium on the at least one cooling surface (35, 15), the receptacle (9) being adapted to receive water dripping from the at least one cooling surface (35, 15).

## Description

### FIELD OF THE INVENTION

The present invention relates to dehumidification.

### BACKGROUND OF THE INVENTION

Humidity is harmful to many electronic components. Humidity is an issue for example in solar power plants and wind power plants. Challenging environment such as tropical climate or arctic climate increases problems caused by humidity.

In a known method air inside a device chamber is heated after which the heated moist air is discharged from the device chamber, said cycle being repeated until air inside the device chamber is warm and dry. It is also known to use water absorbing materials such as silica gel to remove humidity from a device chamber.

Dehumidification by repeated drying cycles discharging heated humid air and replacing said discharged air with colder ambient air is a relatively slow process requiring plenty of energy. Water absorbing materials are expensive and their useful life is limited.

### BRIEF DESCRIPTION OF THE INVENTION

An object of the present invention is to provide a method and an apparatus for implementing the method so as to alleviate the above disadvantages. The objects of the invention are achieved by a dehumidification method and a cooling assembly which are characterized by what is stated in the independent claims. The preferred embodiments of the invention are disclosed in the dependent claims.

The invention is based on the idea of condensing water from device chamber cooling medium by cooling thereof at a safe place at a distance from electronic components that could be damaged by humidity. The condensed water may be discharged from a device chamber containing the electronic components or stored inside the device chamber in a harmless place where the water does not endanger the electronic components.

An advantage of the method and assembly of the invention is that cooling medium in a device chamber can be dried relatively fast without need to discharge heated cooling medium from the device chamber.

### DETAILED DESCRIPTION OF THE INVENTION

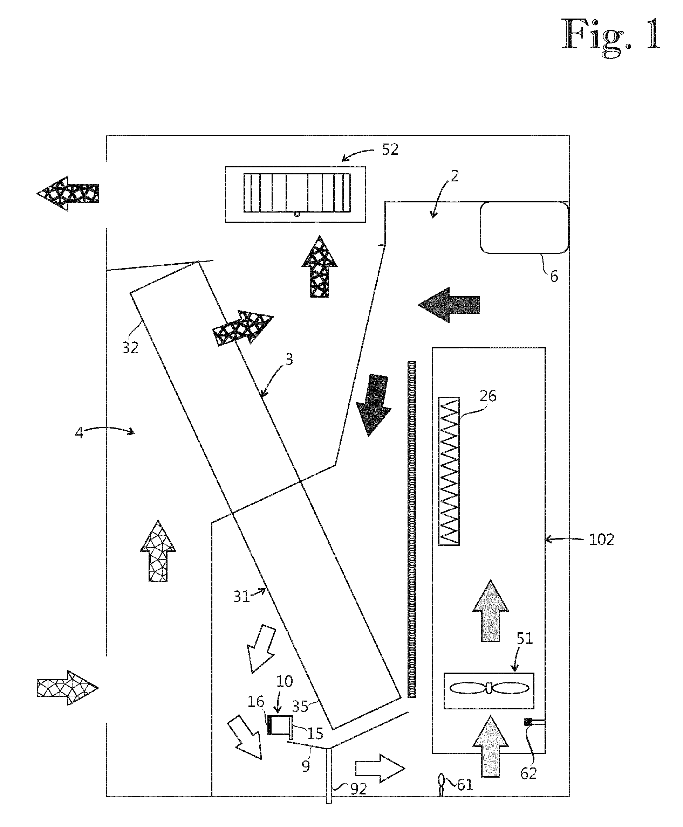

In the following the invention will be described in greater detail by means of preferred embodiments with reference to the attached Figure 1 illustrating a cooling assembly according to an embodiment of the invention.

Figure 1 shows a cooling assembly comprising a device chamber 2, a cooling chamber 4, heat exchanger means, humidity sensor means 61, heating means 26, device chamber fan means 51, cooling chamber fan means 52, control means 6, a receptacle 9, and a discharge tube 92. The device chamber 2 contains air as device chamber cooling medium, and the cooling chamber 4 contains air as cooling chamber cooling medium. The device chamber 2 is separated from the cooling chamber 4 such that there is substantially no cooling medium flow between the device chamber 2 and the cooling chamber 4.

The heat exchanger means comprise a device chamber cooling unit 3 and an internal heat exchanger unit 10. The device chamber cooling unit 3 is adapted for transferring heat from the device chamber 2 to the cooling chamber 4. The device chamber cooling unit 3 comprises a first portion 31 located in the device chamber 2 and a second portion 32 located in the cooling chamber 4, the first portion 31 being in an operating situation located lower than the second portion 32. The first portion 31 has a cooling surface 35 in contact with the device chamber cooling medium. The internal heat exchanger unit 10 is adapted for transferring heat from a cooling surface 15 of the internal heat exchanger unit 10 to a hot surface 16 of the internal heat exchanger unit 10. Both the cooling surface 15 of the internal heat exchanger unit and the hot surface 16 of the internal heat exchanger unit are in contact with the device chamber cooling medium. The hot surface 16 is cooled by circulation of the device chamber cooling medium.

A cooling assembly according to an alternative embodiment of the invention does not comprise a cooling chamber. A device chamber cooling unit of such an embodiment is adapted to transfer heat out of the device chamber, for example to ambient air surrounding the device chamber.

The device chamber cooling unit 3 is a cothex type heat exchanger. A cothex is a thermosyphon heat exchanger where cooling medium circulates by means of natural convection without a mechanical pump. In an alternative embodiment a heat exchanger adapted to transfer heat out of the device chamber may comprise another type of passive heat exchanger, or an active heat exchanger.

The internal heat exchanger unit 10 is a Peltier cooler or a thermoelectric cooler adapted to use a Peltier effect to transfer heat from the cooling surface 15 to the hot surface 16. In an alternative embodiment an internal heat exchanger unit adapted to transfer heat from a cooling surface of the internal heat exchanger unit to elsewhere inside the device chamber may comprise a heat exchanger whose type is other than a thermoelectric cooler.

The cooling chamber fan means 52 are adapted for regulating a cooling chamber cooling medium flow interacting with the second portion 32 of the device chamber cooling unit 3. The cooling chamber fan means 52 are capable of exhausting warm air from the cooling chamber and drawing in cold air from exterior of the cooling assembly. Increasing the cooling chamber cooling medium flow increases a cooling power of the device chamber cooling unit 3. The control means 6 are adapted to control the cooling chamber fan means 52.

The humidity sensor means 61 are adapted to detect a humidity level in the device chamber 2, and to provide the control means 6 with information relating to the detected humidity level. The control means 6 are adapted to control the heat exchanger means, and to provide a dehumidification operation as a response to the humidity level exceeding a predetermined threshold value in the device chamber 2. In an embodiment duration of a dehumidification operation is constant, the duration being rated for the cooling assembly in question. Duration of the dehumidification operation may be from 1 to 3 minutes for example. In an alternative embodiment control means are adapted to continue a dehumidification operation until device chamber cooling medium is sufficiently dry.

In many embodiments a decisive humidity level value is a relative humidity level. Since relative humidity level is a function of temperature, the cooling assembly of Figure 1 is depicted with a separate temperature sensor 62 adapted to detect a temperature in the device chamber 2. Alternatively an integrated relative humidity sensor may be used. Since relative humidity of air further depends on pressure, a cooling assembly may be equipped with a pressure sensor.

The dehumidification operation comprises lowering a temperature of the cooling surface 35 of the device chamber cooling unit 3 in order to condensate water from the device chamber cooling medium on the cooling surface 35 of the device chamber cooling unit 3. In order to lower a temperature of the cooling surface 35 of the device chamber cooling unit 3, the control means 6 starts the cooling chamber fan means 52. In an alternative embodiment where a device chamber cooling unit comprises an active heat exchanger a step of lowering a cooling surface of the active heat exchanger may comprise starting of a pump of the active heat exchanger.

Alternatively or additionally the dehumidification operation comprises lowering a temperature of the cooling surface 15 of the internal heat exchanger unit 10 in order to condensate water from the device chamber cooling medium on the cooling surface 15 of the internal heat exchanger unit 10. In order to lower a temperature of the cooling surface 15, the control means 6 switches on the internal heat exchanger unit 10.

The receptacle 9 is adapted to receive water dripping from the cooling surfaces 15 and 35. The discharge tube 92 is adapted for discharging water from the receptacle 9 out of the device chamber 2. The discharge tube 92 has a capillary structure for discharging water from the receptacle 9 out of the device chamber 2.

In an alternative embodiment water received in a receptacle is not discharged from a device chamber. Instead the water is stored inside the device chamber in a harmless place. The stored water may be boiled in order to sterilize the water. The stored water may be used later. Storing water may be useful in a desert or other environment suffering from a shortage of water.

The cooling surface 35 of the device chamber cooling unit 3 is a smooth surface thereby facilitating a downward transfer of water along the cooling surface 35. The cooling surface 35 and the cooling surface 15 of the internal heat exchanger unit 10 each comprise a hydrophobic coating for facilitating dripping of water from the cooling surface to the receptacle 9. Further, the cooling surface 35 of the device chamber cooling unit 3, the cooling surface 15 of the internal heat exchanger unit 10, and an inner surface of the receptacle 9 comprises anti-bacterial material.

The heating means 26 are adapted for heating the device chamber 2. The heating means 26 are provided for a cold start situation in order to raise a temperature and/or lower relative humidity in the device chamber 2 to a suitable level. The heating means 26 are spaced apart from the cooling surfaces 15 and 35. In the embodiment of Figure 1 the heating means 26 are located inside an electrical apparatus 102 accommodated in the device chamber 2. In alternative embodiments the heating means may be located elsewhere in the device chamber.

The electrical apparatus 102 comprises a frequency converter. In an alternative embodiment an electrical apparatus located in the device chamber may comprise an inverter or some other heat generating apparatus that requires cooling when operating.

The heating means 26 may be used in the dehumidification operation for heating the device chamber cooling medium in order to evaporate moisture in the device chamber 2. Transfer of the heated device chamber cooling medium containing evaporated moisture to the cooling surfaces 15 and 35 may be facilitated by the device chamber fan means 51 adapted for circulating device chamber cooling medium in the device chamber 2. In the embodiment of Figure 1 the device chamber fan means 51 are located inside the electrical apparatus 102 accommodated in the device chamber 2. In alternative embodiments the device chamber fan means may comprise one or more fans located outside the electrical apparatus. Device chamber fan means may be used for circulating device chamber cooling medium in a device chamber also in embodiments with no heating means.

The dehumidification operation may comprise alternately heating the device chamber 2 with the heating means 26 and lowering a temperature of the cooling surface 35 and/or cooling surface 15. The steps of heating the device chamber and lowering a temperature of the cooling surfaces may be overlapped such that the temperature lowering step begins before the heating step ends. In an alternative embodiment the heating step and the temperature lowering step are carried out simultaneously.

It will be obvious to a person skilled in the art that the inventive concept can be implemented in various ways. The invention and its embodiments are not limited to the examples described above but may vary within the scope of the claims.

## Claims

1. A cooling assembly comprising
a device chamber (2) containing device chamber cooling medium, heat exchanger means comprising at least one cooling surface (35, 15) in contact with the device chamber cooling medium,
control means (6) adapted to control the heat exchanger means, humidity sensor means (61) adapted to detect a humidity level in the device chamber (2), and
a receptacle (9),
the control means (6) being adapted to provide a dehumidification operation as a response to the humidity level exceeding a predetermined threshold value in the device chamber (2),
**characterized in that** the dehumidification operation comprises lowering a temperature of the at least one cooling surface (35, 15) in order to condensate water from the device chamber cooling medium on the at least one cooling surface (35, 15), the receptacle (9) being adapted to receive water dripping from the at least one cooling surface (35, 15).

2. A cooling assembly according to claim 1, **characterized in that** the cooling assembly comprises a discharge tube (92) for discharging water from the receptacle (9) out of the device chamber (2).

3. A cooling assembly according to claim 2, **characterized in that** the discharge tube (92) has a capillary structure for discharging water from the receptacle (9) out of the device chamber (2).

4. A cooling assembly according to any preceding claim, **characterized in that** the heat exchanger means comprise a device chamber cooling unit (3) for transferring heat out of the device chamber (2), the device chamber cooling unit (3) comprising a first portion (31) located in the device chamber (2) and a second portion (32) located outside the device chamber (2), the first portion (31) having a cooling surface (35) in contact with the device chamber cooling medium.

5. A cooling assembly according to claim 4, **characterized in that** the first portion (31) of the device chamber cooling unit (3) is in operating situation located lower than the second portion (32) of the device chamber cooling unit (3).

6. A cooling assembly according to any preceding claim, **characterized in that** the heat exchanger means comprise an internal heat exchanger unit (10) for transferring heat from a cooling surface (15) of the internal heat exchanger unit (10) to elsewhere inside the device chamber (2).

7. A cooling assembly according to any preceding claim, **characterized in that** the cooling assembly further comprises heating means (26) for heating the device chamber (2), the heating means (26) being spaced apart from the at least one cooling surface (35, 15), the dehumidification operation further comprising heating the device chamber cooling medium with the heating means (26) in order to evaporate moisture in the device chamber (2).

8. A cooling assembly according to claim 7, **characterized in that** the dehumidification operation comprises alternately heating the device chamber (2) with the heating means (26) and lowering a temperature of the at least one cooling surface (35, 15).

9. A cooling assembly according to claim 7 or 8, **characterized in that** the cooling assembly further comprises device chamber fan means (51) for transferring device chamber cooling medium from the heating means (26) to the at least one cooling surface (35, 15).

10. A cooling assembly according to any preceding claim, **characterized in that** the at least one cooling surface (35, 15) comprises a hydrophobic coating for facilitating dripping of water from the at least one cooling surface (35, 15) to the receptacle (9).

11. A cooling assembly according to any preceding claim, **characterized in that** the at least one cooling surface (35, 15) and/or inner surface of the receptacle (9) comprises anti-bacterial material.

12. A dehumidification method comprising:
detecting a humidity level in a device chamber (2) containing device chamber cooling medium,
**characterized in that** the method further comprises:
as a response to the humidity level exceeding a predetermined threshold value in the device chamber (2), lowering a temperature of at least one cooling surface (35, 15) in contact with the device chamber cooling medium in order to condensate water from the device chamber cooling medium on the at least one cooling surface (35, 15), and
collecting water dripping from the at least one cooling surface (35, 15) in a receptacle (9).

13. A dehumidification method according to claim 12, **characterized in that** the method further comprises:
heating the device chamber cooling medium in order to evaporate moisture in the device chamber (2), the heating being carried out at a distance from the at least one cooling surface (35, 15), and
transferring the heated device chamber cooling medium containing evaporated moisture to the at least one cooling surface (35, 15).

14. A dehumidification method according to claim 13, **characterized in that** the steps of heating the device chamber cooling medium and lowering a temperature of the at least one cooling surface (35, 15) are repeated alternately.
